# EUROPEAN PATENT APPLICATION

(11) **EP 2 248 778 A1**
(43) Date of publication of application: **10.11.2010**
(21) Application number: 10250781.1
(22) Date of filing: 15.04.2010
(51) Int. Cl.: C03C 15/00, G03F 7/075

(54) **Microprocessing of synthetic quartz glass substrate**

(30) Priority: 16.04.2009 JP 2009099494
(71) Applicant: Shin-Etsu Chemical Co., Ltd., Tokyo (JP)
(72) Inventor: Yamazaki, Hiroyuki, Joetsu-shi Niigata-ken (JP); Takeuchi, Masaki, Joetsu-shi Niigata-ken (JP)
(74) Representative: Stoner, Gerard Patrick

(57) **Abstract**

In a process for microprocessing a synthetic quartz glass substrate by wet etching, an organic coating layer of silane or silazane is formed on the substrate, and a photoresist film is formed on the organic coating layer, prior to the wet etching.

## Description

### TECHNICAL FIELD

This invention relates to a process for microprocessing a synthetic quartz glass substrate for use in the field of microelectromechanical systems (MEMS), micro-total analysis systems (µ-TAS), and biology where formation of fine features is required.

### BACKGROUND

In microprocessing of synthetic quartz glass by etching with hydrofluoric acid or the like, a protective film consisting of a metal or metal oxide thin film and a photoresist film is formed. When a metal or metal oxide film is formed, the internal stress of the film itself has an impact on the width of features formed during subsequent etching. It is difficult to determine optimum conditions under which a metal or metal oxide film is formed. Usually formation of a metal or metal oxide film suffers from high costs and low throughputs because a capital-intensive apparatus is used and film deposition and removal in vacuum is necessary. Additionally, an apparatus or etching liquid is necessary for film removal, raising a problem of gas or liquid discharge.

If the protective film for etching is formed of only a photoresist film without depositing metal or metal oxide, it does not withstand long-term etching. Particularly when quartz glass is etched, etching must be continued for a long time until the desired depth is reached, because quartz glass has an extremely lower etching rate than other glasses. The photoresist film used alone merely allows for etching to a depth of about 10 µm at maximum (see JP-A 2008-024543).

### Citation List

Patent Document 1: JP-A 2008-024543

When a glass substrate is etched through a mask (photoresist film), insufficient adhesion between the photoresist film and the glass substrate may give rise to a problem that features formed by etching have an unintended lateral spread or uneven shape. Although the problem is overcome by interposing at least one metal or metal oxide film between the photoresist film and the glass substrate, this common approach raises other problems as discussed above. It would be desirable to solve these problems.

An object herein is to provide new and useful processes for processing synthetic quartz glass substrates, enabling protracted etching (such as to a depth of more than 10 µm) at good dimensional tolerance, without great expense and reducing or avoiding the above-mentioned problems of metal and metal oxide films.

The inventors have found that when a coating film of organic compound is formed on a glass substrate, instead of a metal or metal oxide film, as the undercoat below a photoresist layer, the substrate can be etched to a depth of several tens of micrometers, without stripping of the film, to form features having a lateral dimensional accuracy equivalent to that available with the metal or metal oxide film, and the overall process time can be reduced.

According to the invention, an organic coating is formed instead of the metal or metal oxide film between a photoresist film and a glass substrate. The organic coating can be formed at a low cost as compared with the metal or metal oxide, enhances the adhesion between the photoresist film and the glass substrate, and helps display a drastically enhanced performance in terms of etching resistance which is improved over the photoresist film used alone and fully comparable to the metal or metal oxide film.

The invention provides a process for microprocessing a synthetic quartz glass substrate by wet etching, the substrate including a region to be etched and a region to be mask-protected, the process comprising the steps of forming an organic coating layer on at least the mask-protected region of the substrate, and forming a photoresist film on the organic coating layer, prior to the wet etching.

In a preferred embodiment, the organic coating layer comprises a silazane compound or a compound having the general formula (1):

R₄₋ₙSiXₙ (1)

wherein R is each independently a substituted or unsubstituted, straight, branched or cyclic alkyl group of 1 to 18 carbon atoms, aryl or aralkyl group of 6 to 18 carbon atoms, or unsaturated aliphatic hydrocarbon group of 2 to 18 carbon atoms, X is chlorine, methoxy or ethoxy, and n is an integer of 1 to 3.

In a preferred embodiment, the wet etching uses an etching liquid containing hydrofluoric acid or a fluoride salt.

### ADVANTAGEOUS EFFECTS

According to our findings, a protective film can be briefly formed at a low cost on a synthetic quartz substrate which is to be wet etched for use in the MEMS, µ-TAS and biological fields requiring formation of fine features of the order of several tens of nanometers to several hundreds of micrometers. The impact of an internal stress which is generated within a metal or metal oxide film itself when it is deposited need not be taken into account, and a study on complex deposition conditions is unnecessary. A dimensional tolerance at least equal to that of the metal or metal oxide film is available.

### FURTHER EXPLANATIONS; OPTIONS AND PREFERENCES

The synthetic quartz glass substrate used herein is manufactured by starting with an organic silane compound as the raw material and effecting reaction in an oxyhydrogen flame to form a synthetic quartz glass ingot. The ingot is worked and annealed into the desired shape, subjected to surface or cylindrical grinding, and sliced to the desired thickness. A glass substrate as sliced is subjected to surface grinding and optionally external cylindrical grinding, and then to rough polishing and precise polishing. The substrate as polished is then cleaned to remove particles and contaminants. If particles and contaminants are left on the substrate, they eventually cause failures in flowpath processing.

According to the invention, an organic coating is formed on the synthetic quartz glass substrate. For the organic coating, not only its adhesion to a photoresist film, but also its adhesion to the quartz glass substrate surface are important. Thus the organic coating is preferably formed of a compound having a functional group having an ability to bond or a high affinity to hydroxyl groups pendant from the quartz glass substrate surface.

Suitable compounds include compounds having the general formula (1) shown below and silazane compounds such as tetramethyldisilazane, hexamethyldisilazane, diphenyltetramethyldisilazane, hexamethylcyclotrisilazane, heptamethyldisilazane, divinyltetramethyldisilazane, and octamethylcyclotetrasilazane.

R₄₋ₙSiXₙ (1)

Herein R which may be the same or different is a substituted or unsubstituted, straight, branched or cyclic alkyl group of 1 to 18 carbon atoms, an aryl or aralkyl group of 6 to 18 carbon atoms, or an unsaturated aliphatic hydrocarbon group of 2 to 18 carbon atoms, X is a chlorine atom, methoxy group or ethoxy group, and n is an integer of 1 to 3. R may be a substituted form of the foregoing group in which some or all hydrogen atoms are substituted by fluorine atoms, primary to tertiary amino, epoxy, methacryloxy or acryloxy groups.

Examples of the compound of formula (1) include, but are not limited to, methyltrichlorosilane, dimethyldichlorosilane, trimethylchlorosilane, phenyltrichlorosilane, butyltrichlorosilane, cyclohexyltrichlorosilane, decyltrichlorosilane, n-octyltrichlorosilane, dodecyltrichlorosilane, tetradecyltrichlorosilane, octadecyltrichlorosilane, t-butyldimethylchlorosilane, allyltrichlorosilane, allylchlorodimethylsilane, allyltriethoxysilane, allyltrimethoxysilane, diethoxymethylvinylsilane, vinyltrichlorosilane, vinyltrimethoxysilane, vinyltriethoxysilane, p-styryltrimethoxysilane, methyltrimethoxysilane, methyltriethoxysilane, ethyltriethoxysilane, dimethyldimethoxysilane, dimethyldiethoxysilane, phenyltrimethoxysilane, phenyltriethoxysilane, dimethoxyethylphenylsilane, diphenyldimethoxysilane, n-propyltrimethoxysilane, n-propyltriethoxysilane, hexyltrimethoxysilane, hexyltriethoxysilane, n-octyltriethoxysilane, decyltrimethoxysilane, n-dodecyltriethoxysilane, trifluoropropyltrimethoxysilane, octadecyltrimethoxysilane, and octadecyltriethoxysilane.

These compounds are able to react with the quartz glass substrate surface to form bonds and possess a lipophilic alkyl chain having a high affinity to a photoresist layer. They are thus suited to form the organic coating.

The method for preparing a coating solution from which the organic coating is formed must be determined in accordance with the application technique. Suitable application techniques include dipping, spin coating, spraying, and vapor phase deposition. In the case of dipping, spin coating and spraying, the coating solution may be adjusted to an optimum concentration, or in some cases, the compound e.g. of formula (1) must be pre-treated or pre-reacted e.g. by hydrolysis. For vapor phase deposition, a compound liquid is often used to form the vapor. Spin coating and vapor phase deposition are more preferred because uniform treatment is more practical.

After application, baking is optionally carried out for the purposes of promoting reaction and adhesion between the coated solution and the substrate surface and evaporating off the unreacted components. Removal of the unreacted components may also be effected by washing with pure water or organic solvents after the baking treatment.

Once the organic coating is formed, a photoresist film is applied. The photoresist film to be applied may be selected from various positive and negative photoresist materials for i-line, KrF, and ArF lithography and the like, depending on the intended device. Preferably the photoresist film which is resistant to etching with an aqueous solution of hydrofluoric acid or fluoride salt is used.

With respect to the thickness of the photoresist film, a thicker film is preferred for resistance to etching, but the optimum thickness is somewhat limited by the line width of the intended device and the performance of the exposure tool or the like. Although the thickness of the photoresist film should be selected for a particular application, the thickness is generally in a range of 0.5 to 3 µm, and preferably 1 to 2 µm.

Application of the photoresist film may be carried out by spin coating, spraying or the like. In the case of spin coating which is most often used, parameters of spin coating including rotation count, rotation time, and multi-stage rotation must be determined so as to facilitate uniform coating, depending on the viscosity of photoresist material and the desired thickness of photoresist film. Coating is followed by baking, known as prebaking. While the prebaking temperature and time affect the time and finish of the subsequent exposure and development, prebaking is generally at 80 to 110°C for 1 to 30 minutes.

Before coating, during coating, and before baking, deposition of foreign matter on the surface should be avoided. The contaminants detract from the adhesion between the photoresist film and the organic coating and become a cause of pits and other defects during subsequent etching.

Next, the photoresist film on the substrate is exposed patternwise by light exposure through a mask having the desired pattern or by direct writing with electron beam, ion beam or the like, to define a photoresist pattern. The exposure dose may be determined in accordance with the type and thickness of the photoresist film and the resist pattern.

The photoresist film thus exposed is developed in a developer, whereby the exposed portion is removed from the positive film, and the unexposed portion is removed from the negative film. The time and count of development must be selected optimum depending on various factors including developer concentration, photoresist type, baking conditions, film thickness, and pattern line width. In contrast to the exposure dose, approximate values may be selected for the development because no substantial problems arise in most cases. When the developer in a development tank is repeatedly used, a longer development time becomes necessary with the lapse of service time. Then the developer must be carefully managed so as to avoid short development while taking into account the lifetime of the developer.

The development is followed by baking, known as post-baking. Post-baking may be at a temperature of 120°C or higher for a time of 10 minutes or longer. The post-baking treatment functions to desensitize and reinforce the photoresist pattern, but need not always be conducted. For a particular device, the post-baking treatment is intentionally omitted. Since the post-baking treatment affects the strength of the photoresist film, though to a less extent than the prebaking, the post-baking temperature and time need considerations.

Next, the quartz glass substrate is etched using the photoresist pattern as a mask. Strictly stated, the organic coating is present on the quartz glass substrate surface where the photoresist film has been removed. Preferably this organic coating is removed beforehand by dry etching, wet etching or the like. If the type and coating conditions of the organic coating are properly selected, it can be removed by the aqueous solution for etching the quartz glass substrate. Thus separate removal of the organic coating is not always necessary. One problem at this point is whether or not the organic coating is removed at a uniform rate. Since the organic coating itself is thin enough to be removed within a brief time, the extent of etching of the quartz glass substrate surface before the removal of the organic coating is completed is of no significance.

Etching of the quartz glass substrate is preferably carried out in an aqueous solution of hydrofluoric acid or a fluoride salt in a concentration of about 1 to about 20% by weight. Suitable fluoride salts include sodium fluoride and ammonium fluoride. The etching solution may be an aqueous solution of hydrofluoric acid and a fluoride salt in admixture, to which a surfactant may be added. Such a solution is effective for uniform and consistent etching. To achieve the desired etching level in a consistent manner, etching parameters including temperature, time, and solution volume must be properly controlled.

### EXAMPLE

Examples of the invention are given below by way of illustration and not by way of limitation.

### Example 1

A quartz glass substrate having undergone lapping to final polishing steps was cleaned in accordance with the standard semiconductor cleaning procedure. An organic coating treatment was performed at the end of cleaning and before the cleanness was impaired. A 1 wt% aqueous solution was prepared by hydrolyzing dimethyldiethoxysilane (Shin-Etsu Chemical Co., Ltd.) in the presence of an acid catalyst. The solution was spin coated onto the substrate by dropwise addition and spinning at 500 rpm, and heat treated at 120°C for 10 minutes.

Next, an i-line positive photoresist material S1813 (Rohm & Haas) was spin coated onto the substrate at 3,000 rpm and baked at 100°C for 2 minutes to form a protective film for etching.

The coated substrate was exposed to light through a mask pattern for image transfer, developed, and baked by heat treatment at 130°C for 10 minutes.

Next, the coated substrate was immersed in a 10 wt% hydrofluoric acid aqueous solution at room temperature for 8 hours for etching, forming features of 50 µm deep. A widthwise spread of a feature was measured under a microscope, finding errors within ±1 µm relative to the etching width of 100 µm. The features had substantially no lateral spread, demonstrating that a combination of photoresist film with organic coating was very effective.

### Example 2

The procedure of Example 1 was repeated except that hexamethyldisilazane (Shin-Etsu Chemical Co., Ltd.) was used instead of dimethyldiethoxysilane, and the substrate was treated by bubbling nitrogen into the hexamethyldisilazane for evaporation. An accuracy of processing equivalent to Example 1 was obtained.

### Comparative Example 1

The procedure of Example 1 was repeated except that no organic coating was formed. Some portions of the resist film peeled off during etching. The shape of some features deviated from the corresponding mask pattern and a number of etch pits generated in the portion to be protected. Even in the area where the resist film appeared to be retained, features had a lateral spread of several tens of micrometers.

### Comparative Example 2

The procedure of Example 1 was repeated except that a conventional metal film was deposited instead of the organic coating. Features of the desired shape were obtained, but some features had a lateral processing error of the order of +2 µm.

## Claims

1. A process for microprocessing a synthetic quartz glass substrate by wet etching, the substrate including a region to be etched and a region to be mask-protected, the process comprising the steps of:
forming an organic coating layer on at least the mask-protected region of the substrate, and
forming a photoresist film on the organic coating layer, prior to the wet etching.

2. A process of claim 1 wherein the organic coating layer is made using silazane compound, or compound of the general formula (1):
R₄₋ₙSiXₙ (1)
wherein each R independently is a substituted or unsubstituted, straight, branched or cyclic alkyl group of 1 to 18 carbon atoms, aryl or aralkyl group of 6 to 18 carbon atoms, or unsaturated aliphatic hydrocarbon group of 2 to 18 carbon atoms, X is chlorine, methoxy or ethoxy, and n is an integer of 1 to 3.

3. A process of claim 1 or 2 in which the organic coating is formed by applying to the substrate surface a coating solution containing a compound for forming said coating, with optional heat treatment, or by vapor-phase deposition on the substrate surface of a compound for forming said coating.

4. A process of claim 1, 2 or 3 in which the photoresist film is formed to a thickness of from 0.5 to 3 µm.

5. A process of any one of the preceding claims wherein the wet etching uses an etching liquid containing hydrofluoric acid or fluoride salt.

6. A process of any one of the preceding claims wherein after patterning exposure and development of the photoresist film, the organic coating remains on the substrate at regions where the photoresist film has been removed, and may be removed by said process of wet etching the glass substrate.
